Europäisches Patentamt

European Patent Office

Office européen des brevets

(19)

(11) Numéro de publication : **0 008 263**
**B1**

(12) **FASCICULE DE BREVET EUROPÉEN**

(45) Date de publication du fascicule du brevet :
03.02.82

(51) Int. Cl.³ : **H 03 K 4/72, H 04 N 3/16**

(21) Numéro de dépôt : **79400520.7**

(22) Date de dépôt : **20.07.79**

(54) **Circuit de balayage trame en mode commuté pour récepteur vidéo-fréquence, et récepteur comportant un tel circuit.**

(30) Priorité : **27.07.78 FR 7822266**

(43) Date de publication de la demande :
**20.02.80 (Bulletin 80/04)**

(45) Mention de la délivrance du brevet :
**03.02.82 Bulletin 82/05**

(84) Etats contractants désignés :
**BE DE GB IT NL SE**

(56) Documents cités :
**DE - B - 1 289 097**
**FR - A - 2 262 442**
**FR - A - 2 318 545**

(73) Titulaire : **"THOMSON-BRANDT"**
**173, bld Haussmann**
**F-75360 Paris Cedex 08 (FR)**

(72) Inventeur : **Rilly, Gérard**
**"THOMSON-CSF" - SCPI 173, bld Haussmann**
**F-75360 Paris Cedex 08 (FR)**

(74) Mandataire : **Thierr, Françoise et al**
**"THOMSON-CSF"- SCPI 173, bld Haussmann**
**F-75360 Paris Cedex 08 (FR)**

Imprimerie Jouve, 18, rue St-Denis, 75001 Paris, France

Circuit de balayage trame en mode commuté pour récepteur vidéo-fréquence, et récepteur
comportant un tel circuit

La présente invention concerne un circuit de balayage trame en mode commuté, tel que ceux utilisés dans les récepteurs de télévision.

Une image de télévision est obtenue par le déplacement d'un spot sur l'écran d'un tube cathodique, de la gauche vers la droite et du haut vers le bas.

Le déplacement du spot de la gauche vers la droite est assuré par des bobines, dites bobines de déviation horizontale ou de balayage ligne, parcourues par un courant de forme adéquate et le déplacement du haut vers le bas est assuré par des bobines, dites de déviation verticale, ou de balayage trame.

Ces bobines de déviation verticale sont, quant à elles, parcourues par un courant généralement en forme de dents de scie. Ce courant possède, pour le standard français, une période de 20 ms et doit présenter une durée de retour de balayage trame inférieure à 1 ms.

Pour un tel courant en dents de scie, il est admis en première approximation, que les bobines de déviation verticale se comportent principalement comme une résistance pendant l'aller de balayage trame, correspondant à la partie visible sur l'écran qui exige une bonne linéarité, et comme une inductance durant le retour de balayage trame.

De nombreux dispositifs ont été mis au point pour engendrer ce courant en dents de scie à la fréquence trame.

L'invention vise un tel circuit du type en mode commuté à découpage.

Un circuit de ce type a été décrit par exemple dans le brevet français 2 318 545.

Dans un tel circuit l'énergie nécessaire pour engendrer le courant traversant le déviateur vertical est fournie par les impulsions de retour de balayage ligne qui sont appliquées sur l'enroulement primaire d'un transformateur présentant deux enroulements secondaires alimentant, par l'intermédiaire d'un moyen de filtrage à inductances et condensateur, la bobine de déviation verticale. Un thyristor respectif est en série avec chaque enroulement secondaire. L'un de ces enroulements secondaires est destiné à alimenter la bobine de déviation verticale pendant le balayage de la moitié supérieure de l'image tandis que l'autre enroulement secondaire est destiné à alimenter la bobine de déviation verticale pendant le balayage de la moitié inférieure de l'image.

La variation désirée en dents de scie du courant dans la bobine de déviation verticale, mesurée par une résistance de contre réaction d'échantillonage de courant, est obtenue en prévoyant, d'une part, un générateur de signaux de tension en dents de scie représentant le courant souhaité dans la bobine de trame et, d'autre part, un convertisseur ou modulateur pour qu'à chaque période de balayage ligne, chaque thyristor soit conducteur pendant un temps qui est fonction du niveau du signal de tension produit par ce générateur.

Le circuit de ce brevet français nécessite deux voies, qui, en pratique, doivent fonctionner simultanément afin d'obtenir un bon raccordement des deux demi-trames au centre de l'écran.

Ce choix de deux voies, monodirectionnelles en courant, chacune dans un sens différent, est imposé par la charge, c'est-à-dire le déviateur vertical (self de retour de balayage et résistance série d'aller de balayage) en série avec une résistance de mesure de son courant, qui se comporte toujours en récepteur d'énergie, imposant ainsi au générateur de dents de scie d'être bidirectionnel en courant et bidirectionnel en tension.

Le circuit de balayage vertical selon l'invention est d'une plus grande simplicité que celui décrit dans le brevet français mentionné ci-dessus et est par conséquent plus économique à réaliser.

Il est caractérisé en ce qu'un condensateur de liaison étant en série avec la bobine de déviation verticale, la capacité de ce condensateur a une valeur suffisamment élevée pour que la tension aux bornes de l'ensemble en série comprenant le condensateur et la bobine de déviation verticale garde toujours un signe constant, cette charge se comportant ainsi alternativement en récepteur et en générateur d'énergie. On peut ainsi utiliser un seul interrupteur actif qui est alors monodirectionnel en tension et bidirectionnel en courant. Ce circuit de balayage est donc particulièrement simple car il ne comporte qu'un seul interrupteur actif et il ne nécessite ainsi qu'un seul enroulement secondaire de transformateur ligne ; en outre les moyens de filtrage peuvent être plus simples que dans le circuit dudit brevet français.

Il est certes déjà connu (brevet français 2 262 442) de disposer un condensateur en série avec la bobine de déviation verticale dans un circuit à amplificateur en classe D. Mais, outre le fait que ce circuit connu n'est pas du type à découpage — donc à faible consommation d'énergie — ce circuit comprend deux voies, comme celui du brevet FR 2 318 545.

D'autres caractéristiques de l'invention ressortiront de la description suivante, donnée à titre d'exemple non limitatif et illustrée par les figures annexées qui représentent :

les figures 1a et b, l'impédance de charge d'un générateur de dents de scie classique, et la représentation graphique de la tension à ses bornes en fonction du courant qui la traverse ;

les figures 2a et b, l'impédance de charge d'un générateur de dents de scie selon l'invention, et la représentation graphique de la tension à ses bornes en fonction du courant qui la traverse ;

la figure 3, un schéma d'un circuit de balayage trame en mode commuté selon l'invention.

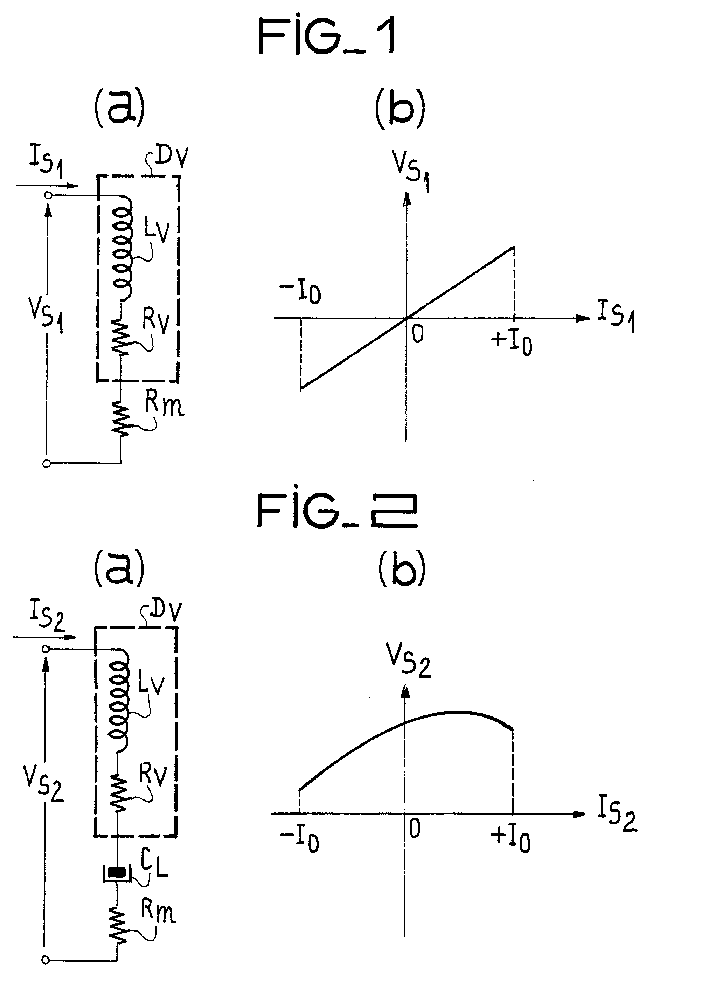

La figure 1a représente l'impédance de charge d'un circuit de balayage trame classique. Elle comporte le déviateur vertical $D_V$ composé d'une inductance $L_V$ en série avec une résistance $R_V$, et une résistance Rm de mesure du courant traversant le déviateur.

$V_{S1}$ représente la tension aux bornes de cette charge, et $I_{S1}$ le courant. Par convention, le sens des flèches symbolise le cas d'une tension positive.

La figure 1b visualise les valeurs de la tension $V_{S1}$ en fonction des valeurs du courant $I_{S1}$.

La charge se comporte toujours en récepteur d'énergie et travaille sur les quadrants $V_{S1}$, $I_{S1}$ positifs et $V_{S1}$, $I_{S1}$ négatifs. Le courant $I_{S1}$ varie entre les valeurs limites + Io et − Io qui représentent les valeurs positives et négatives maximales du courant traversant le déviateur, + Io correspondant au début de balayage trame (haut de l'écran) et − Io à la fin (bas de l'écran).

La tension $V_{S1}$ suit en fonction du courant $I_{S1}$ une droite passant par le point zéro.

La figure 2a représente l'impédance de charge d'un circuit de balayage trame selon l'invention. Elle est composée d'un déviateur vertical $D_V$, d'une résistance de mesure Rm et d'un condensateur de liaison $C_L$.

La tension $V_{S2}$ représente la tension aux bornes de cette charge et le courant $I_{S2}$, le courant qui la traverse. Le sens indiqué par les flèches est, par convention, celui d'une tension et d'un courant positifs.

Le condensateur $C_L$ est du type électrochimique polarisable, et est choisi de manière à avoir à ses bornes une tension dont la valeur moyenne soit suffisamment élevée et positive d'après la convention de signe précédente. En effet, cette tension va s'ajouter aux tensions aux bornes du déviateur $D_V$ et de la résistance Rm, et va permettre d'obtenir, par sa valeur élevée, une tension $V_{S2}$ toujours positive aux bornes de la charge quel que soit le sens du courant dans le déviateur ; ceci dans les limites de courant − Io et + Io.

La variation de la tension $V_{S2}$ en fonction du courant de déviation $I_{S2}$ est représentée à la figure 2b.

Pour un courant variant entre les valeurs extrêmes − Io et + Io, la charge travaille sur les quadrants $V_{S2}$, $I_{S2}$ positifs, et $V_{S2}$ positif, $I_{S2}$ négatif. Elle se comporte donc dans un premier temps en récepteur d'énergie et dans un second temps en générateur.

Le générateur de dents de scie de trame doit donc être monodirectionnel en tension et bidirectionnel en courant.

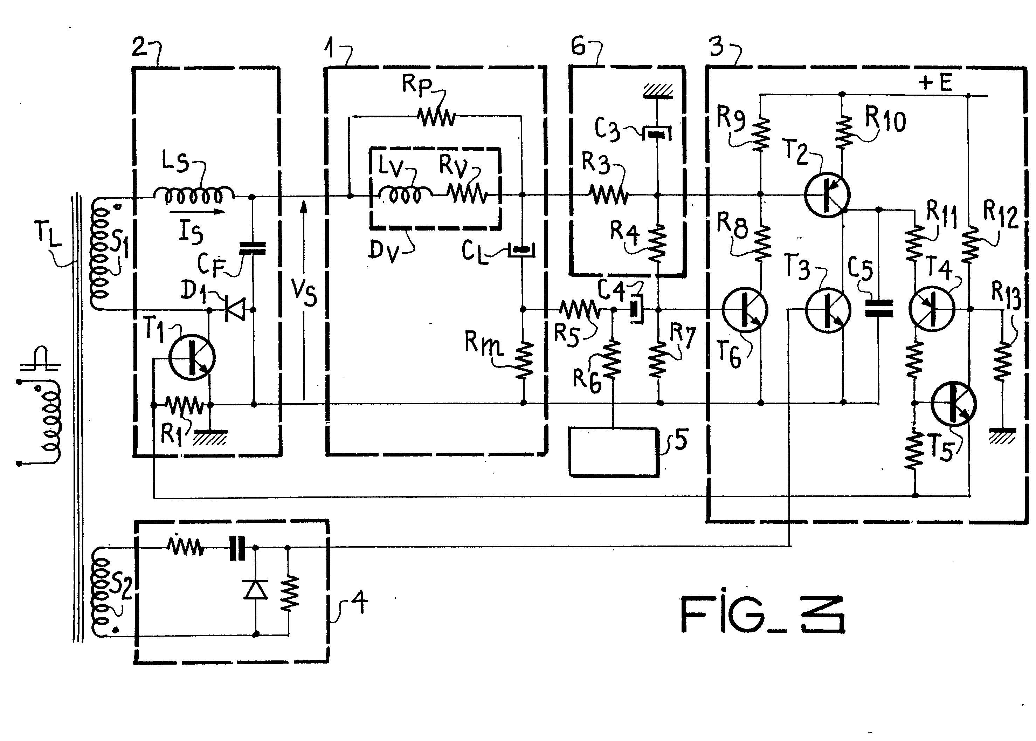

Selon l'invention on réalise ce générateur à l'aide d'un seul interrupteur actif tel que représenté à la figure 3.

En effet, la figure 3 représente un schéma d'un circuit de balayage trame en mode commuté selon l'invention.

La charge 1, comporte le déviateur vertical $D_V$ protégé par une résistance parallèle $R_p$, le condensateur de liaison $C_L$ et la résistance de mesure de courant Rm. Elle est connectée aux bornes d'un circuit 2 générateur d'un signal en dents de scie grâce à un circuit de commande 3 synchronisé à la fréquence ligne, par un circuit 4.

Ce circuit 2 engendre dans le déviateur vertical $D_V$ un signal en dents de scie à partir des signaux de retour de balayage ligne.

En effet, lors du retour de balayage, il apparaît dans les enroulements secondaires du transformateur ligne, un signal alternatif périodique à la fréquence ligne.

Le courant en dents de scie est obtenu par un découpage de ce signal alternatif engendré dans un enroulement secondaire auxiliaire du transformateur ligne. Ce découpage est effectué à l'aide d'un interrupteur actif bidirectionnel en courant et monodirectionnel en tension, connecté en série avec l'enroulement $S_1$ ainsi qu'avec une inductance $L_S$ non couplée au transformateur ligne, l'ensemble étant monté en parallèle avec un condensateur de filtrage $C_F$.

La valeur du condensateur $C_F$ est choisie suffisamment grande pour que la partie alternative de la tension à ses bornes soit très faible devant le signal aux bornes de l'enroulement $S_1$, et donc négligeable.

L'interrupteur actif comporte une diode $D_1$ montée en parallèle avec un transistor $T_1$ du type NPN. Son collecteur est connecté à la cathode de la diode, son émetteur à l'anode de la diode d'une part et à la masse d'autre part. Sa base est connectée à la masse à travers une résistance $R_1$. Cette base est également reliée à un circuit de commande 3.

Le transistor peut être aussi du type PNP, dans ce cas son émetteur est connecté à la cathode de la diode et à la borne non à la masse du condensateur $C_F$. Son collecteur est connecté à l'anode de la diode et à une borne de l'inductance Ls.

On peut également utiliser un thyristor en parallèle avec une diode, ou encore tout autre interrupteur actif. Dans le cas où l'on prévoit un thyristor l'anode de ce dernier est connectée, d'une part, à la cathode de la diode et, d'autre part, à une borne de l'enroulement secondaire du transformateur ligne, et la cathode de ce thyristor est connectée à l'anode de la diode qui est elle-même connectée à la masse. Sa gâchette est reliée au circuit de commande synchronisé à la fréquence ligne.

Le transistor $T_1$ fonctionne en interrupteur, c'est-à-dire que lorsque son courant base est suffisant pour qu'il soit saturé, il court-circuite la diode $D_1$.

Un tel interrupteur actif composé du transistor $T_1$ et de la diode $C_1$ est bidirectionnel en courant et monodirectionnel en tension. En effet lorsqu'il est fermé, il peut être parcouru par des courants de sens opposés, et lorsqu'il est ouvert il a à ses bornes une tension d'une polarité déterminée, correspondant à la tension inverse de la diode $D_1$.

Durant l'aller de balayage trame, l'enroulement $S_1$ du transformateur ligne $T_L$ délivre des impulsions de retour ligne de forme quasiment sinusoïdale. Le condensateur $C_F$ constitue avec l'inductance $L_V$ du déviateur vertical $D_V$, un filtre passe-bas très efficace vis-à-vis de la fréquence ligne, et le courant traversant le déviateur est pratiquement égal à la valeur moyenne du courant $I_S$ traversant l'inductance $L_S$.

En effet, supposons dans un premier temps pour faciliter la compréhension de l'invention que le transistor $T_1$ est toujours ouvert, c'est-à-dire qu'aucun signal n'est injecté sur sa base.

Dans ce cas, la tension engendrée par l'enroulement secondaire $S_1$, qui est périodique à la fréquence ligne est redressée par la diode $D_1$ et filtrée par le filtre passe-bas formé par l'inductance $L_V$ et le condensateur $C_F$ qui est de valeur suffisamment grande pour que la tension alternative à ses bornes soit négligeable.

La tension aux bornes du condensateur $C_F$ est donc continue et positive, et impose ainsi une tension continue positive aux bornes de la charge 1.

La tension aux bornes de l'inductance $L_S$ est égale à la tension aux bornes de l'enroulement secondaire $S_1$ moins la tension $V_S$ aux bornes du condensateur $C_F$ tant que la diode $D_1$ est parcourue par un courant direct, la tension à ses bornes étant quasiment nulle.

La forme de la tension aux bornes de l'inductance $L_S$ est donc semblable à celle de la tension aux bornes de l'enroulement $S_1$ pendant tout le temps de conduction de la diode $D_1$. Lorsque la diode $D_1$ est bloquée cette tension est nulle.

A partir de l'instant où la tension aux bornes de l'enroulement $S_1$ devient positive, la diode $D_1$ est parcourue par un courant direct, et la tension aux bornes de l'inductance $L_S$ est positive. La tension aux bornes de l'inductance $L_S$ prend donc la forme d'une sinusoïde positive semblable à celle de la tension aux bornes de l'enroulement $S_1$, jusqu'à l'instant de fin de retour de balayage ligne, où elle prend une valeur négative qu'elle conserve jusqu'à l'instant de blocage de la diode $D_1$, c'est-à-dire à l'instant d'annulation du courant dans le circuit, donc à l'annulation du courant dans l'inductance $L_S$.

En effet, le courant dans l'inductance $L_S$ croît tant que la tension à ses bornes est positive, puis décroît linéairement jusqu'à atteindre une valeur nulle quand elle devient négative.

Le courant moyen à travers le condensateur $C_F$ étant nul, le courant circulant dans le déviateur vertical est égal au courant moyen traversant l'inductance $L_S$.

Dans le cas particulier où le transistor $T_1$ est toujours bloqué ce courant moyen est donc positif.

Supposons maintenant que l'on ferme le transistor $T_1$ en injectant sur sa base, par l'intermédiaire du circuit de commande 3, un signal de niveau suffisant, à un instant précédant l'instant de début de retour de balayage ligne. La diode $D_1$, qui était polarisée par une tension négative imposée par la tension aux bornes de l'enroulement secondaire $S_1$, et qui était bloquée, se trouve alors court-circuitée. L'interrupteur actif $T_1D_1$ est donc fermé, et la tension aux bornes de la diode $D_1$ est nulle.

Tant que cette tension est nulle, la tension aux bornes de l'inductance $L_S$ est égale à la tension aux bornes de l'enroulement $S_1$ moins la tension aux bornes du condensateur $C_F$ qui est continue, positive.

La tension aux bornes de l'enroulement $L_S$ est donc constante et négative jusqu'à l'instant de début de retour ligne où elle commence à croître en suivant une forme sinusoïdale semblable à celle de la tension aux bornes de l'enroulement $S_1$. Après un maximum positif en milieu de retour de balayage ligne, cette tension décroît jusqu'à une valeur négative à l'instant de fin de retour de balayage ligne, valeur qu'elle conserve jusqu'à l'annulation du courant dans le circuit, c'est-à-dire jusqu'à l'annulation du courant dans l'inductance $L_S$.

La tension aux bornes de l'inductance $L_S$ étant d'abord négative, le courant la traversant est négatif et décroît linéairement jusqu'à un minimum. L'instant de ce minimum correspond à l'instant où la tension aux bornes de $L_S$ s'annule avant de devenir positive. Après cet instant, le courant dans l'inductance $L_S$ croît, s'annule à l'instant où la tension aux bornes de $L_S$ est maximum, et atteint un maximum positif, à l'instant où la tension redevient nulle avant de redevenir négative. Après cet instant le courant décroît linéairement jusqu'à s'annuler.

Le courant moyen à travers le condensateur $C_F$ étant nul, le courant circulant dans le déviateur vertical $D_V$ est égal au courant moyen traversant l'inductance $L_S$.

La forme du courant dans l'inductance $L_S$ dépendant de l'instant de fermeture du transistor $T_1$, son courant moyen en dépend aussi, ainsi que le courant circulant dans le déviateur vertical.

Plus le transistor $T_1$ est déclenché à un instant en avance sur l'instant de début de retour ligne, et plus le courant moyen dans l'inductance $L_S$ décroît par rapport à sa valeur maximum correspondant au cas où le transistor $T_1$ est toujours bloqué.

On peut donc contrôler la valeur du courant moyen dans l'inductance $L_S$, donc la valeur du courant dans le déviateur en contrôlant l'instant de fermeture du transistor $T_1$.

Pendant l'aller de balayage trame, pour que le courant dans le déviateur vertical suive une loi en dents de scie trame, il suffit donc de commander convenablement les instants successifs de fermeture du transistor $T_1$.

En début de retour de balayage trame, les conditions électriques initiales sont : une tension alternative nulle aux bornes du condensateur $C_F$, une tension positive aux bornes du condensateur $C_L$ et un courant dans le déviateur vertical $D_V$ égal à une valeur minimum qui est appelée − Io.

Le circuit formé par la charge I et le condensateur $C_F$, et qui se présente dans les conditions initiales, mentionnées ci-dessus, entre en résonnance à la fréquence d'accord déterminée par l'inductance $L_V$ et le condensateur $C_F$.

Au bout d'une demi-période de la période d'accord, le courant dans le déviateur vertical $D_V$ s'inverse et atteint une valeur maximum positive

égale à + lo.

Le temps de retour trame est donc donné par la durée correspondant à l'inversion complète de − lo à + lo.

Une commande convenable du transistor $T_1$ est assurée par le circuit 3 représenté à la figure 3.

Ce circuit assure la fermeture du transistor $T_1$ en injectant sur sa base un signal de niveau convenable, à un instant dépendant du courant ainsi que de la tension de sortie, et de la tension fournie par l'enroulement secondaire $S_1$ du transformateur de ligne.

Un transistor $T_6$ a sa base connectée à travers un condensateur de liaison $C_4$ et une résistance $R_5$, à une borne de la résistance de mesure Rm.

D'autre part, un circuit 5 fournissant une tension en dent de scie corrigée, c'est-à-dire une très bonne image de la forme du courant nécessaire à une bonne déviation verticale, est connecté à travers les résistances $R_6$ et $R_5$ à une borne de la résistance de mesure Rm.

Cette tension en dent de scie corrigée est donc comparée à la tension apparaissant aux bornes de la résistance Rm par le pont de résistances $R_6$, $R_5$.

Le transistor $T_6$, ainsi que le transistor $T_2$ connecté en série avec $T_6$, amplifient le signal d'erreur dynamique éventuel entre la tension aux bornes de la résistance Rm et la tension en dent de scie corrigée.

Or la tension aux bornes de Rm est fonction du courant traversant le déviateur vertical $D_V$.

Le signal d'erreur est donc fonction de la différence entre le courant de déviation vertical et la tension en dent de scie corrigée.

L'amplificateur formé par les transistors $T_6$, $T_2$ est polarisé par les résistances $R_7$, $R_8$, $R_9$, $R_{10}$.

Le courant collecteur du transistor $T_2$ qui est fonction du courant base du transistor $T_6$, est donc fonction de la différence entre la tension aux bornes de la résistance Rm et la tension en dent de scie corrigée.

Le courant collecteur du transistor $T_2$ charge un condensateur $C_5$ connecté entre le collecteur de $T_2$ et la masse.

Un transistor $T_3$ est monté en parallèle avec le condensateur $C_5$, son collecteur étant connecté au collecteur de $T_2$ et son émetteur à la masse. Sa base est reliée à un circuit de synchronisation 4, qui fournit à partir des impulsions de retour ligne provenant d'un enroulement secondaire auxiliaire $S_2$ du transformateur ligne, un signal en créneaux qui commande le transistor $T_3$.

Pour un niveau nul de ce signal, le transistor $T_3$ est bloqué. Lorsque le signal prend une valeur donnée par les caractéristiques intrinsèques du transistor $T_3$, il devient passant et court-circuite le condensateur $C_5$, mettant ainsi en état bloqué un bistable constitué de deux transistors $T_4$ et $T_5$, juste en fin d'impulsion ligne.

En effet l'entrée de ce bistable (émetteur du transistor $T_4$) est connectée au travers d'une résistance $R_{11}$ en sortie collecteur du transistor $T_2$.

Ce bistable est polarisé par les résistances $R_{12}$, $R_{13}$.

Lorsque le transistor $T_3$ est ouvert, le condensateur C5 est chargé par le courant collecteur de $T_2$ qui est fonction de la différence entre la tension aux bornes de Rm et la tension corrigée.

Lorsque la valeur de la tension aux bornes du condensateur $C_5$ dépasse la valeur imposée à la base du transistor $T_4$ par le pont de résistances $R_{12}$, $R_{13}$ le bistable $T_4$, $T_5$ qui était préalablement bloqué devient conducteur, injecte un signal sur la base du transistor $T_1$ qui court-circuite alors la diode $D_1$. Cet état persiste jusqu'à la conduction du transistor $T_3$ qui court-circuite $C_5$ et remet le bistable $T_4$, $T_5$ en état bloqué, juste à la fin de l'impulsion ligne suivante.

L'instant de déclenchement du transistor $T_1$ dépend directement de la pente de la tension de charge du condensateur $C_5$ donc du courant collecteur du transistor $T_2$ et donc de la différence entre le courant dans le déviateur vertical et le signal de référence délivré par le circuit 5.

Lorsque la tension dans la résistance Rm augmente, le courant collecteur du transistor $T_2$ augmente, la pente de la tension aux bornes du condensateur $C_5$ augmente, l'instant de déclenchement $T_1$ est avancé dans le temps, le courant dans le déviateur diminue, et donc la tension aux bornes de la résistance Rm diminue. On a alors une boucle de régulation.

L'asservissement dynamique ainsi réalisé est tel que le courant parcourant le déviateur est l'image de la tension en dent de scie corrigée périodique délivrée par le circuit 5.

D'autre part, pour assurer un bon fonctionnement du circuit selon l'invention, la valeur moyenne de la tension aux bornes du condensateur $C_L$ doit être suffisamment élevée et stable. La stabilité est assurée par la boucle 6 connectée entre le collecteur du transistor $T_6$ et le déviateur vertical $D_V$.

Cette boucle est composée d'une part d'un condensateur polarisé $C_3$ et d'autre part de deux résistances $R_3$, $R_4$ qui assurent aussi la polarisation de la base du transistor $T_6$. Cette boucle permet de contrôler la charge moyenne du condensateur $C_L$ et d'assurer ainsi sa stabilité.

Le circuit de balayage en mode commuté selon l'invention fonctionne donc en n'utilisant qu'un seul interrupteur actif, donc une seule voie, présentant ainsi l'avantage, sur les circuits en mode commuté connu dans l'art antérieur, d'utiliser moitié moins de composants.

Le circuit de balayage trame selon l'invention est principalement utilisé dans les récepteurs de télévision transistorisés.

**Revendications**

1. Circuit de balayage vertical en mode commuté pour récepteur de télévision dans lequel l'énergie nécessaire pour engendrer le courant dans le déviateur vertical ($D_V$) est tirée des impulsions de retour ligne grâce à des moyens de filtrage et à un dispositif interrupteur en série avec ces moyens de filtrage qui est commandé pour qu'à chaque période de balayage de ligne il soit conducteur pendant un temps qui est fonction du niveau souhaité pour le courant dans le déviateur vertical, caractérisé en ce qu'un condensateur de liaison (C_L) étant, de façon en soi connue, en série avec le déviateur vertical, ce condensateur a une capacité de valeur suffisamment élevée pour que la tension aux bornes de l'ensemble en série comprenant le déviateur et ce condensateur garde un signe constant et le dispositif interrupteur comporte un unique interrupteur actif monodirectionnel en tension et bidirectionnel en courant.

2. Circuit selon la revendication 1, caractérisé en ce que les moyens de filtrage comprennent une inductance (L_S) en série d'une part avec l'enroulement secondaire (S_1) d'un transformateur ligne (T_L) dont l'enroulement primaire reçoit des impulsions de retour ligne et d'autre part avec l'interrupteur actif unique (T_1, D_1), et un condensateur (C_F) en parallèle sur l'ensemble en série de l'interrupteur actif, de l'enroulement secondaire et de l'inductance, le déviateur vertical et le condensateur de liaison tirant l'énergie nécessaire à leur fonctionnement de la tension aux bornes du condensateur de filtrage.

3. Circuit selon la revendication 1 ou 2, caractérisé en ce que l'interrupteur actif comporte un transistor (T_1) et une diode (D_1) montés en parallèle mais en sens inverses, les signaux de commande de l'interrupteur étant appliqués sur la base dudit transistor.

4. Circuit selon la revendication 1 ou 2, caractérisé en ce que l'interrupteur actif comporte un thyristor et une diode montés en parallèle mais en sens inverses, le signal de commande de cet interrupteur étant appliqué sur la gâchette du thyristor.

5. Circuit selon l'une quelconque des revendications précédentes, caractérisé en ce qu'il comporte un générateur (5) de signaux de tension sensiblement en dents de scie à la fréquence de balayage vertical représentant le courant désiré dans le déviateur vertical, ce générateur étant relié à l'électrode de commande de l'interrupteur actif par l'intermédiaire d'un convertisseur tension-temps (3) pour qu'à chaque ligne cet interrupteur soit conducteur pendant un temps qui est fonction du niveau du signal engendré par ce générateur.

6. Circuit selon la revendication 5, caractérisé en ce que le convertisseur tension-temps comprend un condensateur (C_5) dont la pente de la tension de charge est fonction du signal d'erreur et qui commande la modification de l'état de conduction de l'interrupteur actif lorsque cette charge atteint une valeur donnée.

7. Circuit selon l'une quelconque des revendications précédentes, caractérisé en ce qu'il comprend une boucle (6) pour stabiliser la valeur moyenne de la tension aux bornes du condensateur de liaison (C_L).

8. Circuit selon la revendication 7, caractérisé en ce que la boucle est reliée à l'entrée du convertisseur tension-temps (3).

9. Récepteur de télévision, caractérisé en ce qu'il comporte un circuit de balayage vertical en mode commuté selon l'une quelconque des revendications précédentes.

**Claims**

1. Switch mode vertical deflection circuit for a television receiver in which the energy necessary for causing the current to flow in the vertical deflector (D_V) is derived from line flyback pulses by filter means and a switch means connected in series with said filter means and controlled in such a manner that in each line scan period the switch means is conductive for a time duration which is a function of the desired level of the current in the vertical deflector, characterized in that a connection capacitor (C_V) is, in a manner known per se, connected in series with said vertical deflector, said capacitor having a capacity value sufficiently high for maintaining a constant sign of the voltage at the terminals of the series group containing the deflector and said capacitor, and in that said switch means contains a unique active switch unidirectional as to voltage and bidirectional as to current.

2. Circuit according to claim 1, characterized in that said filter means contain an inductance (L_S) connected in series on the one hand with the secondary winding (S_1) of a line transformer (T_L), the primary winding of which receives line flyback pulses, and on the other hand with said unique active switch (T_1, D_1), and contain a capacitor (C_F) connected in parallel with a serial group comprising the active switch, the secondary winding and the inductance, said vertical deflector and said connection capacitor deriving the energy necessary for their operation from the voltage at the terminals of said filter capacitor.

3. Circuit according to claim 1 or 2, characterized in that the active switch contains a transistor (T_1) and a diode (D_1) connected in antiparallel manner thereto, the control signals of the switch being applied to the base of said transistor.

4. Circuit according to claim 1 or 2, characterized in that the active switch contains a thyristor and a diode connected in antiparallel manner thereto, the control signal of the switch being applied to the trigger electrode of said thyristor.

5. Circuit according to any one of the preceding claims, characterized by a generator (5) generating essentially sawtooth-shaped voltage signals having the vertical deflection frequency and representing the desired current in the vertical deflector, said generator being connected to the control electrode of said active switch via a voltage-time-converter (3) so that in each line the switch is conductive for a time duration which is a function of the level of the signal generated by said generator.

6. Circuit according to claim 5, characterized in that said voltage-time-converter contains a

capacitor (C₅) the charging voltage slope of which is a function of the error signal and which controls the change of the conducting state of said active switch when this charge reaches a given value.

7. Circuit according to any one of the preceding claims, characterized by a loop (6) for stabilizing the average value of the voltage at the terminals of the connection capacitor (C_L).

8. Circuit according to claim 7, characterized in that said loop is connected to the input of the voltage-time-converter (3).

9. Television receiver, characterized in that it contains a switch mode vertical deflection circuit according to any one of the preceding claims.


**Ansprüche**


1. Im Schaltbetrieb arbeitende Vertikalablenkschaltung für einen Fernsehempfänger, bei dem die zur Erzeugung des im Vertikalablenkorgan (D_V) fließenden Stroms notwendige Energie von Zeilenrücklaufimpulsen mit Hilfe von Filtermitteln und einer damit in Serie geschalteten Schaltervorrichtung abgeleitet wird, die derart gesteuert ist, daß sie in jeder Zeilenablenkperiode während einer Zeitdauer leitend ist, die von der gewünschten Größe des im Vertikalablenkorgan fließenden Stroms abhängt, dadurch gekennzeichnet, daß ein Verbindungskondensator (C_L) in an sich bekannter Weise mit dem Vertikalablenkorgan in Serie geschaltet ist, wobei dieser Kondensator einen Kapazitätswert hat, der genügend hoch ist, damit die Spannung an den Klemmen der Serienschaltung aus dem Ablenkorgan und dem Kondensator ein konstantes Vorzeichen behält, und daß die Schaltervorrichtung einen besonderen aktiven Schalter enthält, der bezüglich Spannung in einer Richtung und bezüglich Strom in zwei Richtungen wirksam ist.

2. Schaltung nach Anspruch 1, dadurch gekennzeichnet, daß die Filtermittel eine Induktivität (L_S) enthalten, die einerseits mit der Sekundärwicklung (S₁) eines Zeilentransformators (T_L), dessen Primärwicklung die Zeilenrücklaufimpulse empfängt, und andererseits mit dem besonderen aktiven Schalter (T₁, D₁) in Serie geschaltet ist, und einen Kondensator (C_F) enthalten, der parallel liegt zur Serienschaltung aus dem aktiven Schalter, der Sekundärwicklung und der Induktivität, wobei das Vertikalablenkorgan und der Verbindungskondensator die für ihren Betrieb notwendige Energie der Spannung an den Klemmen des Filterkondensators entnehmen.

3. Schaltung nach Anspruch 1 oder 2, dadurch gekennzeichnet, daß der aktive Schalter einen Transistor (T₁) und eine dazu antiparallel geschaltete Diode (D₁) enthält, wobei die Steuersignale des Schalters an die Basis des Transistors angelegt sind.

4. Schaltung nach Anspruch 1 oder 2, dadurch gekennzeichnet, daß der aktive Schalter einen Thyristor und eine dazu antiparallel geschaltete Diode enthält, wobei das Steuersignal des Schalters an die Triggerelektrode des Thyristors angelegt ist.

5. Schaltung nach einem der vorhergehenden Ansprüche, gekennzeichnet durch einen Generator (5) zur Erzeugung von den gewünschten Strom durch das Vertikalablenkorgan repräsentierenden Spannungssignalen mit im wesentlichen sägezahnförmigen Verlauf und mit der Vertikalablenkfrequenz, wobei der Generator an die Steuerelektrode des aktiven Schalters über einen Spannungs-Zeit-Umsetzer (3) angeschlossen ist, damit bei jeder Zeile der Schalter während einer Zeitdauer leitet, die von der Größe des von dem Generator erzeugten Signals abhängt.

6. Schaltung nach Anspruch 5, dadurch gekennzeichnet, daß der Spannungs-Zeit-Umsetzer einen Kondensator (C₅) enthält, dessen Ladespannungsgradient vom Fehlersignal abhängt und der die Änderung des leitenden Zustandes des aktiven Schalters steuert, wenn die Ladung einen gegebenen Wert erreicht.

7. Schaltung nach einem der vorhergehenden Ansprüche, gekennzeichnet durch eine Stabilisierungsschleife (6) zum Stabilisieren des Mittelwerts der Spannung an den Klemmen des Verbindungskondensators (C_L).

8. Schaltung nach Anspruch 7, dadurch gekennzeichnet, daß die Stabilisierungsschleife an den Eingang des Spannungs-Zeit-Umsetzers (3) angeschlossen ist.

9. Fernsehempfänger, dadurch gekennzeichnet, daß er eine im Schaltbetrieb arbeitende Vertikalablenkschaltung nach einem der vorhergehenden Ansprüche enthält.

FIG_1

(a)

(b)

FIG_2

(a)

(b)

FIG_3

0 008 263